# FASCICULE DE BREVET EUROPEEN

(11) **EP 3 985 875 B1**
(45) Date de publication et mention de la délivrance du brevet: **08.04.2026**
(21) Numéro de dépôt: 21203029.0
(22) Date de dépôt: 15.10.2021
(51) Int. Cl.: H03K 17/96, B62D 1/04

(54) **DISPOSITIF DE DÉTECTION DE CONTACT MULTIPOINT ET PROCÉDÉ**
VORRICHTUNG ZUR ERFASSUNG VON MEHRPUNKTKONTAKTEN UND ENTSPRECHENDES VERFAHREN
MULTIPOINT CONTACT DETECTION DEVICE AND METHOD

(30) Priorité: 16.10.2020 FR 2010654
(43) Date de publication de la demande: 20.04.2022
(73) Titulaire: Commissariat à l'Energie Atomique et aux Energies Alternatives, 75015 Paris (FR)
(72) Inventeur: PORTE, Florian, 38054 GRENOBLE Cedex 09 (FR); MORVILLIER, Raphaël, 38054 GRENOBLE Cedex 09 (FR); PRAT, Christophe, 38054 GRENOBLE Cedex 09 (FR)
(74) Mandataire: Ipsilon

(56) Documents cités:
- WO-A1-2020/193142
- US-A1- 2012 296 528
- US-A1- 2018 354 543
- US-A1- 2020 158 540

## Description

### Domaine technique

La présente invention concerne les dispositifs de détection de contact multipoints, en particulier ceux utilisant des capteurs capacitifs ou inductifs et mesurant une variation de fréquence produite par la proximité, le contact et la pression des mains d'une personne sur une surface ainsi que les procédés de localisation et d'estimation de la pression de contact.

### Technique antérieure

Dans le cadre de la voiture autonome et de l'amélioration de la sécurité automobile, on observe une volonté des constructeurs d'instrumenter l'habitacle dans l'idée de capturer un maximum d'informations sur l'état du conducteur.

La mesure de la pression des mains sur le volant, lorsqu'elle est combinée avec d'autres données physiologiques, est un bon indicateur de l'état mental du conducteur, comme par exemple son état de fatigue ou de stress et la baisse de vigilance qui en résulte.

Un grand nombre de dispositifs permettant de détecter un contact des mains avec le volant grâce à des capteurs disposés sur celui-ci ont ainsi été proposés.

Le brevet US5969616 décrit une méthode de détection de la pression des mains du conducteur sur le volant, grâce à un revêtement compressible attaché au volant et à une mesure de résistivité électrique.

La demande EP1537002 décrit un dispositif de détection du contact des mains grâce à des éléments piézo-électriques.

Le brevet US8983732 divulgue un système de sécurité automobile comportant une pluralité de capteurs de pression disposés sur le volant du véhicule, destinés à détecter la présence des mains du conducteur sur le volant.

La demande JP2016190570 décrit un système de détection des mains par mesure capacitive.

La demande WO2020109181 décrit un dispositif de détection de la présence des mains, comportant des électrodes de détection capacitive disposées sur le volant, reliées à un circuit de mesure commun à toutes les électrodes.

La demande EP1292485 décrit un système de détection de la position des mains grâce à un ensemble de capteurs résistifs, capacitifs ou inductifs, les capteurs étant plus courts que la largeur d'un doigt afin de distinguer les doigts des pouces.

Le brevet US7109862 décrit un dispositif de détection de la présence des mains sur un volant grâce à des oscillateurs. Ce système ne mesure ni la position des mains sur le volant, ni la pression exercée par celles-ci sur le volant.

Les demandes US20190226879 et DK179908 décrivent des dispositifs comportant un circuit résonnant de type LC pour détecter le contact et la pression de contact d'une personne dans un siège ou de ses mains sur un volant.

La demande CN209842557 décrit un dispositif de reconnaissance de la gestuelle d'une main utilisant un circuit résonnant et comportant plusieurs électrodes formant une structure en U dans laquelle une main en mouvement peut être introduite, la gestuelle étant déterminée par l'analyse de la perturbation induite.

L'article *"Distributed Sensor for Steering Wheel Grip Force Measurement in Driver Fatigue Detection"* décrit un système de détection capacitif de la position des mains comportant huit capteurs répartis sur le volant, comprenant chacun un oscillateur RC et un microcontrôleur mesurant la fréquence émise par l'oscillateur. L'utilisation d'une multitude de microcontrôleurs rend l'intégration de ce dispositif relativement complexe.

La demande US 2018/354543 Al divulgue un organe de manœuvre tel que défini dans le préambule de la revendication 1 en annexe.

Tous ces dispositifs existants ne permettent pas de répondre d'une manière optimale à la fois aux problématiques de la localisation et de la mesure de la pression des mains sur le volant, d'une manière fiable, relativement simple à mettre en œuvre et offrant une précision élevée.

### Exposé de l'invention

Il existe par conséquent un besoin pour perfectionner encore les dispositifs de détection de contact multipoints, notamment afin de disposer d'un dispositif performant, relativement peu onéreux et d'intégration simple.

### Résumé de l'invention

L'invention vise à répondre à ce besoin, selon un premier de ses aspects, grâce à un un organe de manœuvre tel que défini dans la revendication 1 en annexe. Les modes de réalisation préférés sont définis dans les revendications dépendantes de la revendication 1.

Grâce à l'invention, le nombre de zones de détection est supérieur au nombre de structures sensibles, car le contact peut être localisé non seulement au centre des zones de détection primaires, mais également entre elles dans la ou les zones de détection intermédiaires. On peut ainsi accroître la résolution spatiale de la mesure sans pour autant avoir besoin d'autant de structures sensibles que de positions déterminables par détection. Par exemple, il est possible grâce à l'invention d'avoir 2*N zones de détection sur la surface, donc autant de positions déterminables, en utilisant seulement N structures sensibles, grâce au fait que l'on peut non seulement détecter le contact au niveau des zones de détection primaires, mais également déterminer si le contact a lieu près du centre de celles-ci ou au niveau d'une zone de détection intermédiaire.

Pour un nombre de zones de détection fixé, on peut alors diminuer le nombre de structures sensibles, ce qui facilite l'intégration du dispositif.

L'invention porte encore, selon un autre de ses aspects, sur un procédé tel que défini dans la revendication 8 en annexe. Les modes de réalisation préférés sont définis dans les revendications dépendantes de la revendication 8.

La sensibilité à la pression n'étant pas linéaire (car plus importante pour les faibles pressions), elle peut être corrigée par une interpolation polynomiale pour déterminer une courbe de sensibilité. Les coefficients et l'ordre de la courbe de sensibilité pourront par exemple être mesurés en usine sur un banc de calibration par l'application d'une force connue. Cette calibration pourra ensuite être adaptée pour déterminer le décalage (offset) et le coefficient multiplicatif propres à chaque conducteur lors de la mesure des seuils Sprox, Sc et Spmax. La gamme Sc -Spmax peut être segmentée de manière à distinguer M niveaux de pression.

### Brève description des dessins

L'invention pourra être mieux comprise à la lecture de la description détaillée qui va suivre, d'exemples de mise en œuvre non limitatifs de celle-ci, et à l'examen du dessin annexé, sur lequel :
[Fig 1] La figure 1 représente de manière schématique et partielle un exemple de dispositif de détection selon l'invention permettant de détecter la position des mains sur un volant,
[Fig 2] la figure 2 représente deux coupes transversales schématiques et partielles du volant illustrant de manière schématique deux agencements de structure sensible selon l'invention, à savoir capacitive (figure 2A) ou inductive (figure 2B),
[Fig 3] la figure 3 représente de manière partielle et schématique certains détails de réalisation d'un exemple un circuit de traitement selon l'invention,
[Fig 4] la figure 4 est un graphe illustrant l'évolution de la mesure en fonction du temps lorsque les mains sont successivement placées à proximité du volant, en contact sans pression sur le volant ou de façon à serrer le volant,
[Fig 5] la figure 5 est un graphe représentant la réponse mesurée lors du positionnement d'une main sur huit zones de détection successives D1 à D8 réparties sur la circonférence du volant,
[Fig 6] la figure 6 est un graphe analogue à celui de la figure 5, représentant la réponse lors du contact des deux mains disposées côte-à-côte sur le volant, pour plusieurs positions successives,
[Fig 7] la figure 7 est un schéma en blocs illustrant des étapes d'un exemple de procédé de détermination de la position et de la pression de contact selon l'invention,
[Fig 8] la figure 8 est une vue analogue à la figure 7 d'une variante de procédé non couverte par les revendications en annexe, et
[Fig 9] la figure 9 est un schéma en blocs illustrant la prise en compte dans la mesure de l'information délivrée par un accéléromètre.

### Description détaillée

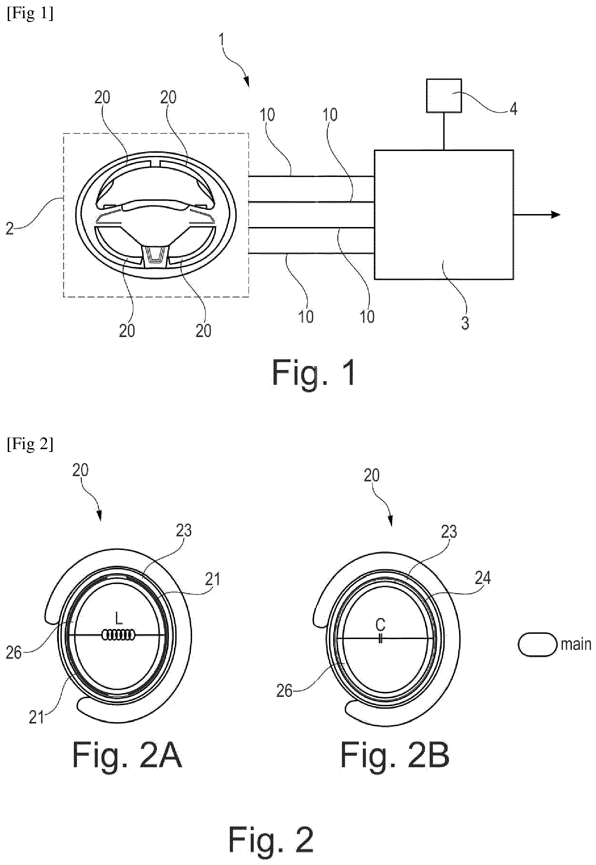

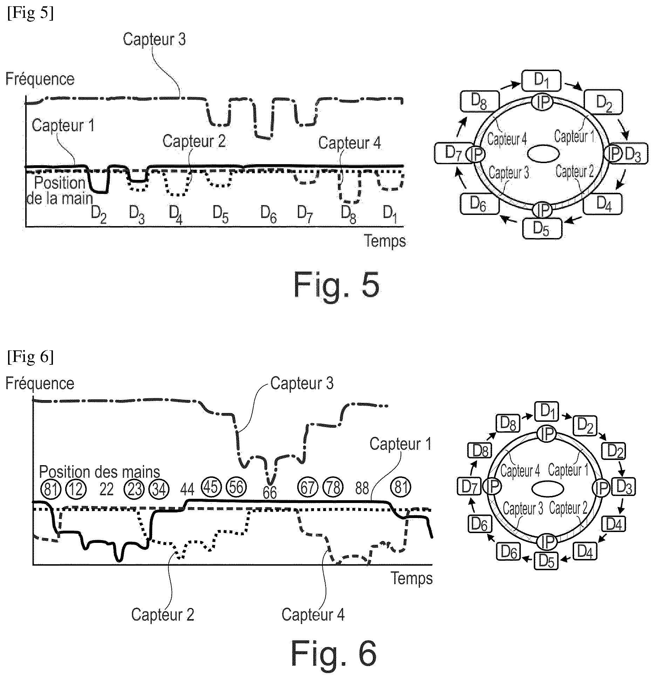

On a illustré à la figure 1 un exemple de dispositif de détection 1 selon l'invention, équipant un volant 2. Ce dispositif 1 comporte N structures sensibles 20, au nombre de quatre dans l'exemple considéré, respectivement dénommées « capteur 1 », « capteur 2 », « capteur 3 » et « capteur 4 » sur la figure 5, permettant de définir 4 zones de détection primaires respectives, référencées D2, D4, D6 et D8 et quatre zones de détection intermédiaires référencées D1, D3, D5 et D7 sur cette figure. Les zones de détection primaires D2, D4, D6 et D8 coïncident avec les structures sensibles 20. Ces dernières sont écartées entre elles, et les zones de détection intermédiaires coïncident avec les espaces situés entre les structures sensibles 20. Chaque zone de détection primaire s'étend sur par exemple un peu moins d'un quart du volant 2. Chaque zone de détection intermédiaire est d'étendue angulaire plus réduite, et une main positionnée sur une zone de détection intermédiaire sera au contact ou à proximité des zones de détection primaires adjacentes.

Chaque structure sensible 20 est reliée par une liaison filaire 10 à un circuit de traitement 3 configuré pour détecter les perturbations induites par la présence des mains sur le volant, afin de localiser le contact.

Le dispositif 1 peut comporter au moins un accéléromètre 4 relié au circuit de traitement 3 et permettant de tenir compte de la perturbation induite par l'accélération sur la mesure effectuée au moyen des structures sensibles 20, comme cela sera détaillé plus loin.

La détection peut mettre en œuvre au moins un oscillateur à circuit résonnant de type LC dont la structure sensible 20 forme tout ou partie de la capacité ou de l'inductance, la venue des mains en contact ou à proximité de la structure sensible 20 induisant une variation de la capacité ou de l'inductance du circuit résonnant LC.

Chaque structure sensible 20 est de préférence capacitive et comporte deux armatures métalliques 21 diamétralement opposées sur la jante 26 du volant, comme illustré à la figure 2A. Sur cette figure, on a représenté de façon schématique l'inductance L du circuit résonnant, associée à la capacité formée par les armatures 21. Cette inductance peut être ou non intégrée au volant et de valeur fixe.

Les armatures 21 peuvent être recouvertes, comme illustré, par un revêtement d'un isolant électrique 23, de préférence un matériau souple compressible, par exemple un élastomère. La présence d'un tel matériau permet de mesurer plus précisément la pression de contact, car ce matériau se déforme lorsque le conducteur appuie dessus, entraînant une variation de la distance de la main aux armatures 21 de la structure sensible. Chaque armature est par exemple de forme rectangulaire, de largeur comprise entre 5 et 30mm.

Dans la variante illustrée à la figure 2B, chaque structure sensible 20 est inductive et comporte par exemple un enroulement 24 bobiné sur la jante 26 du volant, qui forme tout ou partie de l'inductance L du circuit résonant LC. Sur cette figure, on a illustré de manière schématique la capacité C associée, qui peut être non intégrée au volant, et de valeur fixe.

La disposition des armatures 21 selon la figure 2A, à savoir à l'opposé l'une de l'autre, notamment de part et d'autre d'une surface cylindrique médiane coaxiale à l'axe de rotation du volant, permet d'être particulièrement sensible à la pression des mains.

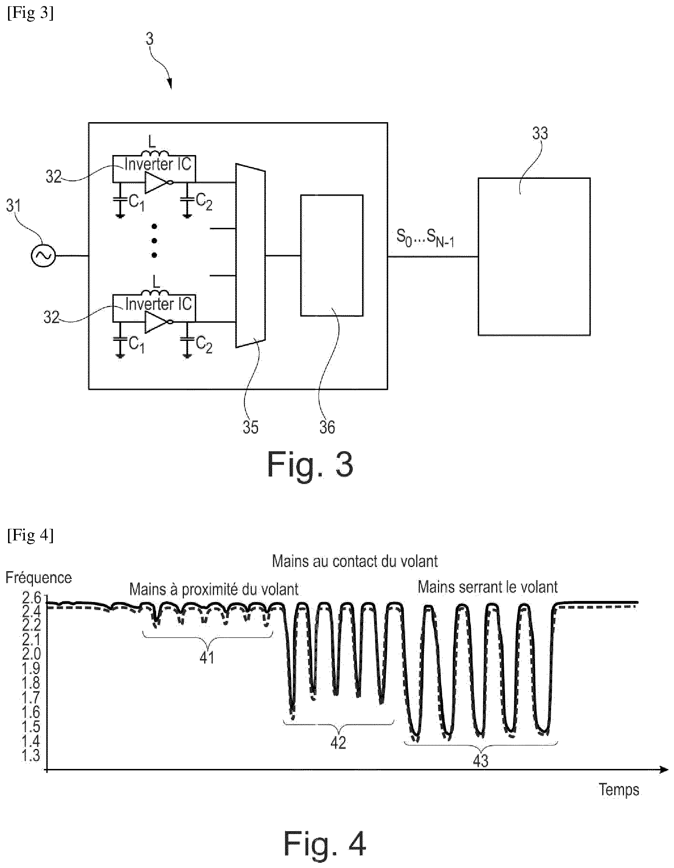

Le circuit de traitement 3 peut comporter un ou plusieurs circuits résonants 32 par exemple de type Colpitts avec un circuit LC comportant comme illustré à la figure 3 une inductance L et deux capacités C₁ et C₂. Le circuit résonant 32 peut comporter comme illustré un inverseur, par exemple un inverseur de type 7404. Dans d'autres exemples, il comporte un transistor (par exemple bipolaire, JFET ou MOSFET) et/ou tout autre amplificateur.

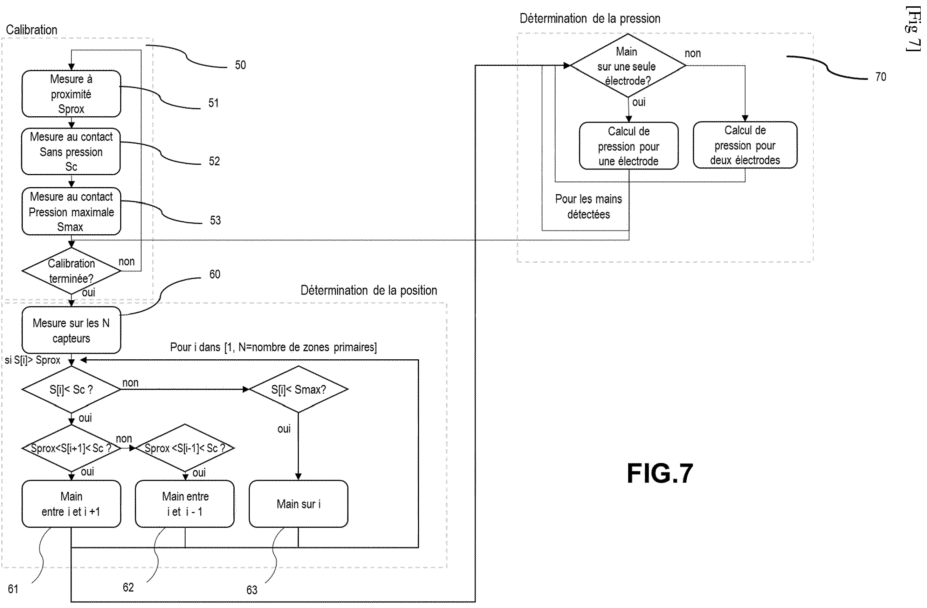

Dans l'exemple illustré, un multiplexeur 35 permet d'alimenter séquentiellement N oscillateurs LC 32 et un processeur 36 détermine et numérise la fréquence de résonance des circuits résonants 32 en comptant le nombre d'oscillations sur une durée définie (en exploitant par exemple l'entrée « timer » du processeur). Le circuit peut recevoir un signal d'horloge 31, par exemple 40MHz. Les N signaux de sortie (S₀ à S_{N-1}) peuvent être traités par un processeur 33 suivant par exemple la méthode décrite à la Figure 7, ou transmis à un autre organe de contrôle qui réalisera le traitement.

Dans l'exemple considéré, la proximité et la pression des mains sur le volant fait varier la fréquence de résonance du circuit LC associé à la structure sensible 20 ainsi sollicitée. Le circuit de traitement 3 est agencé pour générer un signal représentatif de l'amplitude de la variation de fréquence induite par le contact de la personne, comme illustré à la figure 4.

Dans cet exemple, le conducteur positionne une main sur une structure sensible 20 correspondante et effectue, dans l'ordre, les actions suivantes : répétition cinq fois du positionnement des mains à proximité de la structure sensible (signal 41), respectant une distance avec le volant inférieure à 1 cm, suivi d'un éloignement des mains, cinq répétitions avec les mains au contact du volant sans appliquer de pression (signal 42), et cinq répétitions avec les mains serrant le volant avec une pression maximale (signal 43).

Sur la figure 4, chaque courbe correspond à la réponse d'une structure sensible subissant l'action d'une main du conducteur. Le graphe montre que la variation de fréquence induite par la main du conducteur, par rapport à la fréquence de résonnance lorsque la main est éloignée, est représentative de la force de contact. Les trois actions sont ainsi clairement différenciables et les deux zones sensibles produisent une réponse similaire pour les deux mains.

L'utilisation de plusieurs structures sensibles réparties sur la circonférence du volant permet de localiser les mains lorsque celles-ci viennent au contact du volant.

Dans l'exemple considéré, chaque structure sensible 20 occupe un peu moins de 90° sur le volant 2, autour de l'axe de rotation de celui-ci, et l'écart entre les structures sensibles 20 est suffisamment faible pour que le positionnement de la main entre deux structures sensibles adjacentes exerce une perturbation détectable sur ces dernières.

Sur le graphe de la figure 5, on a représenté la réponse des 4 structures sensibles 20 en fonction du positionnement successif d'une main sur les huit zones de détection primaires D2, D4, D6 et D8 (au centre de celles-ci) et intermédiaires D1, D3, D5 et D7.

La venue de la main au contact d'une zone de détection primaire au centre de la structure sensible correspondante 20 peut être détectée par le dépassement d'un seuil d'excursion en fréquence du circuit résonnant associé.

Le positionnement de la main sur une zone de détection intermédiaire peut être détecté par la mesure de l'excursion en fréquence des circuits résonnants associés aux deux zones de détection primaires adjacentes.

A titre d'exemple, lorsque la main est posée sur la zone de détection intermédiaire D5, les courbes représentatives de la perturbation induite sur les structures sensibles 20 associées aux zones de détection primaires D4 et D6 (à savoir les structures sensibles « capteur 2 » et « capteur 3 ») subissent simultanément une excursion en fréquence. Lorsque la main passe en position D6, on observe une perturbation induite plus forte (le creux est plus prononcé) pour le capteur 3, tandis que le capteur 2 n'est plus perturbé.

Sur le graphe de la figure 6, on a représenté la réponse des 4 capteurs en fonction du contact simultané des deux mains sur le volant.

Dans cet exemple, les mains sont positionnées côte à côte, sur une même zone de détection primaire ou sur une zone de détection primaire et une zone de détection intermédiaire adjacente respectivement. Les mains sont déplacées successivement dans le sens des aiguilles d'une montre en partant de la position 81, c'est-à-dire une main sur la zone de détection primaire D8 définie par le capteur 4 et une main sur la zone de détection intermédiaire D1 définie entre le capteur 4 et le capteur 1.

Les mains prennent ainsi successivement 12 positions distinctes, étant déplacées en alternance, c'est-à-dire qu'il y a toujours une main en contact avec le volant durant cette expérience. Les variations de fréquence mesurées pour chaque structure sensible 20 atteignent leur maximum lorsque les deux mains sont en contact avec la zone de détection primaire associée à cette structure sensible, ce qui correspond aux positions 22, 44, 66 ou 88.

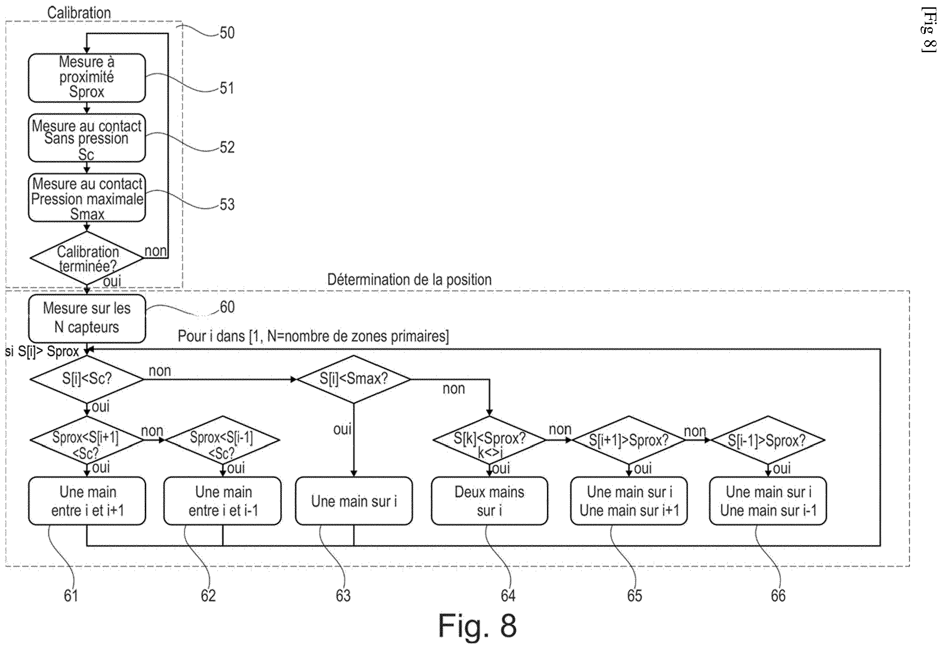

Pour déterminer le point de contact d'une ou plusieurs mains sur le volant, on peut mettre en œuvre des algorithmes tels qu'illustrés sur les figures 7 et 8.

L'algorithme de la figure 7 vise à localiser le contact d'une seule main sur le volant. Dans ce qui suit, l'amplitude de perturbation est par exemple donnée par l'amplitude d'excursion en fréquence du circuit résonnant sous l'effet de la perturbation induite, par rapport à la fréquence de résonnance en l'absence de perturbation.

On détermine d'abord durant une phase de calibration 50, pour chaque zone de détection primaire, trois seuils d'amplitude de perturbation induite sur la structure sensible correspondante, à savoir :
- un seuil Sprox (étape 51), correspondant à la venue à proximité de la zone de détection primaire de la main, sans contact de celle-ci avec cette zone de détection primaire,
- un seuil Sc (étape 52), représentatif du contact de la main avec cette zone de détection primaire sans pression,
- un seuil Spmax (étape 53), représentatif d'une pression maximale exercée par la main sur cette zone de détection primaire.

Une fois cette phase de calibration effectuée, la position de la main sur le volant 2 peut être déterminée en répétant les étapes suivantes :
- on mesure l'amplitude de perturbation induite sur la structure sensible correspondant à chaque zone de détection primaire (étape 60),
- pour j entier compris entre 1 et le nombre N de zones de détection primaires, Sj désignant l'amplitude de perturbation induite sur la structure sensible correspondant à la zone de détection primaire j, et pour Sj>Sprox:
   o Si Sj<Sc et Sprox< Sj+1<Sc (étape 61) alors on détermine que la main est localisée sur la zone de détection intermédiaire entre les zones de détection primaires j et j+1,
   o si Sj<Sc et Sprox<Sj-1<Sc (étape 62) alors on détermine que la main est localisée sur la zone de détection intermédiaire entre les zones de détection primaires j-1 et j,
   o dans le cas contraire, soit Sc<Sj<Spmax, alors on détermine que la main est localisée sur la zone de détection primaire j (étape 63).

Une fois le contact localisé, il est possible d'estimer la pression de contact et/ou l'étendue du contact (étape 70), la perturbation induite augmentant avec la pression de contact et/ou l'étendue de la main située en regard de la structure sensible.

L'algorithme illustré à la figure 8, non couvert par les revendications en annexe, vise à déterminer la position d'une ou de deux mains sur le volant.

On détermine d'abord durant une phase de calibration 50 pour chaque zone de détection primaire, trois seuils d'amplitude de perturbation induite sur la structure sensible Sprox, Sc et Smax, comme décrit précédemment (voir étapes 51 à 53 ci-dessus).

Une fois la calibration terminée, la position des mains sur le volant peut être déterminée en répétant les étapes suivantes :
- on mesure l'amplitude de perturbation induite sur la structure sensible correspondant à chaque zone de détection primaire (étape 60),
- pour j entier compris entre 1 et le nombre N de zones de détection primaires, Sj désignant l'amplitude de la perturbation induite sur la structure sensible correspondant à la zone de détection primaire j, et en supposant Sj>Sprox :
   o Si Sj<Sc et Sprox<Sj+1<Sc alors on détermine que la main est localisée sur la zone de détection intermédiaire entre les zones de détection primaires j et j+1 (étape 61
   o Si Sc<Sj<Spmax alors on détermine que la main est localisée sur la zone de détection primaire j (étape 63),
   o Si Sj<Sc et Sprox<Sj-1<Scalors on détermine que la main est localisée sur la zone de détection intermédiaire entre les zones de détection primaires j-1 et j (étape 62),
   o si Sj>Spmax et Sk<Sprox, pour k<>j, k compris entre 1 et N, alors on détermine que les deux mains sont positionnées dans la zone de détection primaire j (étape 64),
   o si Sj>Spmax d'une part, et Sj+1>Sprox ou Sj-1>Sprox d'autre part, alors on détermine qu'une main est sur la zone de détection primaire j et l'autre main sur la zone de détection primaire j+1 (étape 65) ou sur la zone de détection primaire j-1 adjacente (étape 66).

On utilise de préférence un algorithme tel que celui illustré à la figure 7 lorsqu'il est déterminé au préalable qu'une seule main, au maximum, sera en contact avec le volant, et un algorithme tel que celui illustré à la figure 8 dans les cas où jusqu'à deux mains peuvent contacter le volant.

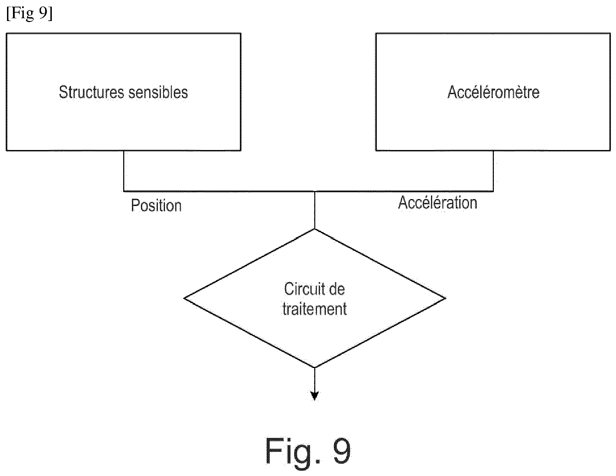

Comme mentionné précédemment, un accéléromètre 4 peut être relié au circuit de traitement 3. Comme illustré à la figure 9, le circuit de traitement 3 peut alors être agencé pour tenir compte de la perturbation induite par l'accélération sur la mesure effectuée au moyen des structures sensibles 20.

Par exemple, tant que le module de l'accélération est supérieur à un seuil prédéfini, la mesure de pression de contact n'est pas prise en compte.

Dans une variante, l'accéléromètre 4 est utilisé pour donner une indication sur la position angulaire du volant qui, corrélée à la position des mains, peut permettre d'évaluer la qualité de la conduite.

L'accéléromètre utilisé est par exemple celui d'un airbag.

Bien entendu, l'invention n'est pas limitée aux exemples qui viennent d'être décrits.

Par exemple, l'invention peut s'appliquer à un organe de manœuvre autre qu'un volant, par exemple un joystick ou une boule ou fourche placée sur le volant pour la conduite d'une seule main, ou être appliquée à la détermination de la posture d'une personne sur un siège.

La détection de la position des mains peut être utilisée pour détecter un comportement anormal du conducteur et/ou l'on peut se servir de la détection d'une gestuelle prédéfinie des mains pour effectuer des commandes.

Par exemple, la détection de deux appuis répétés très rapides sur une zone prédéfinie du volant génère une commande de mise en marche de l'autoradio ou un changement de station. On peut encore déclencher un freinage si par exemple la pression des mains sur le volant dépasse un certain seuil. Le dispositif peut alors servir d'alternative au cercle accélérateur d'un volant pour personnes handicapées.

L'invention peut encore équiper une semelle instrumentée, pour déterminer l'intensité des appuis du pied sur le sol.

L'invention n'est pas limitée à un nombre particulier de structures sensibles, et le nombre de zones de détection intermédiaires peut ne pas être égal au nombre de zones de détection primaires, par exemple si l'on décide que la détermination du positionnement du contact relativement à une ou plusieurs zones de détection primaire est sans intérêt. Par exemple, la surface de détection comporte trois zones de détection primaire, à savoir une située au centre en haut du volant et deux situées sur les côtés, et seulement deux zones de détection intermédiaire, à savoir entre la zone de détection centrale du haut et chacune des zones de détection des côtés. On peut utiliser un plus grand nombre de structures sensibles, avec l'utilisation d'un multiplexeur le cas échéant pour utiliser un même oscillateur avec plusieurs structures sensibles. Par exemple, on utilise plusieurs structures sensibles de petites dimensions, disposées de telle sorte que la main contacte sur sa largeur en même temps plus de deux structures sensibles.

Les circuits oscillants peuvent être réalisés autrement qu'avec des oscillateurs Colpitts, par exemple avec des oscillateurs Hartley, Clapp ou autres.

Les électrodes des structures sensibles peuvent être réalisées de différentes manières et par exemple par impression sur la jante du volant ou sur le revêtement qui le recouvre.

La détermination des différents seuils Sprox, Sc, Spmax et Sj précités peut avantageusement s'effectuer par moyennage sur un ensemble de valeurs lues.

On peut combiner les mesures de position des mains sur le volant effectuées avec d'autres mesures représentatives d'un état physiologique de l'utilisateur, par exemple des mesures d'activité électrodermale, de PPG, ECG afin de déterminer un niveau de stress, de vigilance ou d'endormissement.

On peut mémoriser pour différents conducteurs tout ou partie des seuils résultant de la calibration, afin d'éviter d'avoir à effectuer à nouveau la calibration à chaque changement de conducteur.

## Revendications

1. Organe de manœuvre, équipé d'un dispositif (1) de détection de contact multipoint, comportant :
- au moins deux structures sensibles (20) capacitives ou inductives, associées à des zones de détection primaires respectives (D2 ; D4 ; D6 ; D8) d'une surface qu'une personne est susceptible de contacter, au moins deux de ces structures sensibles étant positionnées avec un écart suffisamment faible entre elles pour définir au moins une zone de détection intermédiaire (D1 ; D3 ; D5 ; D7) que la personne est susceptible de contacter tout en exerçant une perturbation capacitive ou inductive sur les structures sensibles adjacentes,
- un circuit de traitement (3) configuré pour
o détecter pour chaque structure sensible (20) une perturbation induite par la venue de la personne à proximité ou à son contact, le circuit de traitement étant agencé pour générer un signal représentatif de l'amplitude de la perturbation induite par le contact ou la proximité de la personne avec chaque zone de détection primaire (D2 ; D4 ; D6 ; D8), et
o localiser, à partir des perturbations ainsi détectées, la zone de détection primaire ou la zone de détection intermédiaire avec laquelle la personne vient en contact, le contact étant considéré s'effectuer dans une zone de détection intermédiaire (D1 ; D3 ; D5 ; D7) lorsque les perturbations induites sur tout ou partie des zones de détection primaires (D2 ; D4 ; D6 ; D8) satisfont à des relations prédéfinies;
**caractérisé en ce que** le circuit de traitement est en outre configuré pour mesurer la pression de contact de la personne avec la zone de détection primaire ou la zone de détection intermédiaire, le circuit de traitement (3) étant agencé pour générer un signal représentatif de l'amplitude de la perturbation induite par la pression de contact de la personne avec la zone de détection primaire ou la zone de détection intermédiaire.

2. Organe de manœuvre selon la revendication 1 , le circuit de traitement (3) du dispositif (1) étant agencé pour détecter la perturbation induite sur la fréquence d'oscillation d'un oscillateur à circuit résonnant (34) de type LC, dont au moins une partie de la capacité ou de l'inductance est formée par la structure sensible (20), le circuit de traitement (3) du dispositif (1) étant de préférence agencé pour générer un signal représentatif de l'amplitude de la variation de fréquence induite par la pression de contact ou la proximité de la personne avec chaque zone de détection primaire (D2 ; D4 ; D6 ; D8), le circuit de traitement (3) du dispositif (1) étant de préférence agencé pour comparer le signal représentatif de l'amplitude de la perturbation induite sur au moins une structure sensible (20) à au moins un seuil prédéfini (Sprox ; Sc ; Spmax), mieux à au moins deux seuils prédéfinis, et à générer à partir de cette comparaison au moins une information relative à la pression de contact et/ou à l'étendue de contact de la personne sur la zone de détection primaire associée et/ou au moins une information relative à la localisation du contact de la personne sur la surface.

3. Organe de manœuvre selon l'une quelconque des revendications précédentes, le dispositif (1) comportant au moins un accéléromètre (4), le circuit de traitement (3) du dispositif (1) étant agencé pour tenir compte de la perturbation induite par l'accélération sur la mesure effectuée au moyen des structures sensibles (20).

4. Organe de manœuvre selon la revendication 3, le circuit de traitement (3) du dispositif (1) étant agencé pour ignorer le résultat de la mesure effectuée au moyen des structures sensibles (20) lorsque l'accélération détectée est supérieure à un seuil prédéfini.

5. Organe de manœuvre selon l'une quelconque des revendications précédentes, le dispositif (1) comportant au moins trois structures sensibles (20), mieux au moins quatre structures sensibles (20), définissant au moins cinq, mieux au moins huit zones de détection le long de la surface, notamment quatre zones de détection primaires (D2, D4, D6, D8) et entres elles quatre zones de détection intermédiaires (D1, D3, D5, D7).

6. Organe de manœuvre selon l'une quelconque des revendications précédentes, les structures sensibles (20) du dispositif (1) étant distribuées sur l'organe de manœuvre, notamment un volant (2), et le circuit de traitement (3) étant agencé pour délivrer une information représentative de la position de la main sur l'organe de manœuvre.

7. Organe de manœuvre selon l'une quelconque des revendications précédentes, l'organe de manœuvre étant un volant comportant de préférence au moins deux électrodes (21) associées à une même zone de détection primaire sur le volant, ces électrodes étant de préférence diamétralement opposées lorsque l'organe de manœuvre est observé en section.

8. Procédé pour localiser sur une surface un point de contact d'une personne avec cette surface, à l'aide d'un dispositif (1) d'un organe de manœuvre selon l'une quelconque des revendications 1 à 6, procédé dans lequel :
o On détecte pour chaque structure sensible (20) une perturbation induite par la venue de la personne à son contact ou à proximité, et
o on localise, à partir des perturbations ainsi détectées, la zone de détection primaire (D2 ; D4 ; D6 ; D8) ou la zone de détection intermédiaire (D1 ; D3 ; D5 ; D7) avec laquelle la personne vient en contact, le contact étant considéré s'effectuer dans une zone de détection intermédiaire lorsque les perturbations induites sur tout ou partie des zones de détection primaires satisfont à des relations prédéfinies, notamment lorsque les perturbations induites sur chacune des deux zones de détection primaires adjacentes à cette zone de détection intermédiaire dépassent un seuil prédéfini (Sprox), **caractérisé en ce que**, une fois le contact localisé, on estime la pression de contact, la perturbation induite augmentant avec la pression de contact de la main située en regard de la structure sensible..

9. Procédé selon la revendication précédente, dans lequel on détermine durant une étape de calibration (52) pour chaque utilisateur et pour chaque zone de détection primaire un seuil Sc d'amplitude de perturbation induite sur la structure sensible correspondante, représentatif du contact sans pression de la personne avec cette zone de détection primaire, procédé dans lequel on détermine de préférence durant une étape de calibration (53) pour chaque utilisateur et pour chaque zone de détection primaire un seuil Spmax d'amplitude de perturbation induite sur la structure sensible, représentatif d'une pression maximale exercée par la personne sur cette zone de détection, l'intervalle Sc-Spmax étant de préférence segmenté de manière à distinguer au moins deux niveaux de pression, et/ou procédé dans lequel on détermine durant une étape de calibration (51) pour chaque utilisateur et pour chaque zone de détection primaire un seuil Sprox d'amplitude de perturbation induite sur la structure sensible, correspondant à une venue à proximité de la zone de détection primaire de la personne, notamment de sa main, sans contact de celle-ci avec cette zone de détection primaire.

10. Procédé selon l'une des revendications 8 et 9, dans lequel on mesure une accélération à laquelle est soumise la surface et si le module de l'accélération dépasse un seuil prédéfini, la mesure de la perturbation induite sur les structures sensibles est ignorée.

## Patentansprüche

1. Betätigungselement, das mit einer Vorrichtung (1) zur Detektion von Mehrpunktkontakt ausgestattet ist, umfassend:
- mindestens zwei kapazitive oder induktive empfindliche Strukturen (20), die jeweiligen primären Detektionsbereichen (D2; D4; D6; D8) einer Oberfläche zugeordnet sind, die eine Person berühren kann, wobei mindestens zwei dieser empfindlichen Strukturen mit einem ausreichend geringen Abstand untereinander angeordnet sind, um mindestens einen mittleren Detektionsbereich zu definieren (D1; D3; D5; D7), den die Person berühren kann, wobei sie eine kapazitive oder induktive Störung auf die benachbarten empfindlichen Strukturen ausübt,
- eine Verarbeitungsschaltung (3), die dazu ausgestaltet ist
o für jede empfindliche Struktur (20) eine Störung zu detektieren, die durch das Gelangen der Person in die Nähe oder in Kontakt mit ihr bewirkt wird, wobei die Verarbeitungsschaltung dazu ausgebildet ist, ein Signal zu erzeugen, das für die Amplitude der Störung repräsentativ ist, die durch den Kontakt oder die Nähe der Person zu jedem primären Detektionsbereich (D2; D4; D6; D8) bewirkt wird, und
∘ ausgehend von den so detektierten Störungen den primären Detektionsbereich oder den mittleren Detektionsbereich zu orten, mit dem die Person in Kontakt gelangt, wobei der Kontakt als in einem mittleren Detektionsbereich (D1; D3; D5; D7) ausgeführt betrachtet wird, wenn die in allen oder einem Teil der primären Detektionsbereiche (D2; D4; D6; D8) bewirkten Störungen vordefinierte Gleichungen erfüllen;
**dadurch gekennzeichnet, dass** die Verarbeitungsschaltung ferner dazu ausgestaltet ist, den Kontaktdruck der Person mit dem primären Detektionsbereich oder dem mittleren Detektionsbereich zu messen, wobei die Verarbeitungsschaltung (3) dazu ausgebildet ist, ein Signal zu erzeugen, das für die Amplitude der durch den Kontaktdruck der Person mit dem primären Detektionsbereich oder dem mittleren Detektionsbereich bewirkten Störung repräsentativ ist.

2. Betätigungselement nach Anspruch 1, wobei die Verarbeitungsschaltung (3) der Vorrichtung (1) dazu ausgebildet ist, die Störung zu detektieren, die an der Oszillationsfrequenz eines Oszillators (34) mit einem Resonanzkreis vom Typ LC bewirkt wird, bei dem mindestens ein Teil der Kapazität oder der Induktivität durch die empfindliche Struktur (20) gebildet wird, wobei die Verarbeitungsschaltung (3) der Vorrichtung (1) vorzugsweise dazu ausgebildet ist, ein Signal zu erzeugen, das für die Amplitude der Frequenzänderung repräsentativ ist, die durch den Kontaktdruck oder die Nähe der Person zu jedem primären Detektionsbereich (D2; D4; D6; D8) bewirkt wird, wobei die Verarbeitungsschaltung (3) der Vorrichtung (1) vorzugsweise dazu ausgebildet ist, das für die Amplitude der an mindestens einer empfindlichen Struktur (20) bewirkten Störung repräsentative Signal mit mindestens einem vordefinierten Schwellenwert (Sprox; Sc; Spmax), besser mit mindestens zwei vordefinierten Schwellenwerten, zu vergleichen und ausgehend von diesem Vergleich mindestens eine Information bezüglich des Kontaktdrucks und/oder des Kontaktausmaßes der Person in dem zugeordneten primären Detektionsbereich und/oder mindestens eine Information bezüglich der Lage des Kontakts der Person auf der Oberfläche zu erzeugen.

3. Betätigungselement nach einem der vorhergehenden Ansprüche, wobei die Vorrichtung (1) mindestens einen Beschleunigungsmesser (4) umfasst, wobei die Verarbeitungsschaltung (3) der Vorrichtung (1) dazu ausgebildet ist, die Störung zu berücksichtigen, die durch die Beschleunigung auf die mittels der empfindlichen Strukturen (20) durchgeführte Messung bewirkt wird.

4. Betätigungselement nach Anspruch 3, wobei die Verarbeitungsschaltung (3) der Vorrichtung (1) dazu ausgebildet ist, das Ergebnis der mittels der empfindlichen Strukturen (20) durchgeführten Messung zu ignorieren, wenn die detektierte Beschleunigung über einem vordefinierten Schwellenwert liegt.

5. Betätigungselement nach einem der vorhergehenden Ansprüche, wobei die Vorrichtung (1) mindestens drei empfindliche Strukturen (20), besser mindestens vier empfindliche Strukturen (20) umfasst, die mindestens fünf, besser mindestens acht Detektionsbereiche entlang der Oberfläche definieren, insbesondere vier primäre Detektionsbereiche (D2, D4, D6, D8) und zwischen ihnen vier mittlere Detektionsbereiche (D1, D3, D5, D7).

6. Betätigungselement nach einem der vorhergehenden Ansprüche, wobei die empfindlichen Strukturen (20) der Vorrichtung (1) auf dem Betätigungselement, insbesondere einem Lenkrad (2), verteilt sind, und wobei die Verarbeitungsschaltung (3) dazu ausgebildet ist, eine Information auszugeben, die für die Position der Hand auf dem Betätigungselement repräsentativ ist.

7. Betätigungselement nach einem der vorhergehenden Ansprüche, wobei das Betätigungselement ein Lenkrad ist, das vorzugsweise mindestens zwei Elektroden (21) umfasst, die einem selben primären Detektionsbereich an dem Lenkrad zugeordnet sind, wobei diese Elektroden vorzugsweise diametral entgegengesetzt sind, wenn die Betätigungselement im Querschnitt betrachtet wird.

8. Verfahren zum Orten, auf einer Oberfläche, eines Kontaktpunktes einer Person mit dieser Oberfläche mithilfe einer Vorrichtung (1) eines Betätigungselements nach einem der Ansprüche 1 bis 6, wobei bei dem Verfahren:
o Für jede empfindliche Struktur (20) eine Störung detektiert wird, die durch das Gelangen der Person in Kontakt mit ihr oder in ihre Nähe bewirkt wird, und
o ausgehend von den so detektierten Störungen der primäre Detektionsbereich (D2; D4; D6; D8) oder der mittlere Detektionsbereich (D1; D3; D5; D7) geortet wird, mit dem die Person in Kontakt gelangt, wobei der Kontakt als in einem mittleren Detektionsbereich erfolgt betrachtet wird, wenn die in allen oder einem Teil der primären Detektionsbereiche bewirkten Störungen vordefinierte Gleichungen erfüllen, insbesondere wenn die in jedem der beiden zu diesem mittleren Detektionsbereich benachbarten primären Detektionsbereichen bewirkten Störungen einen vordefinierten Schwellenwert (Sprox) überschreiten, **dadurch gekennzeichnet, dass**, sobald der Kontakt geortet ist, der Kontaktdruck geschätzt wird, wobei die bewirkte Störung mit dem Kontaktdruck der Hand, die der empfindlichen Struktur zugewandt ist, zunimmt.

9. Verfahren nach dem vorhergehenden Anspruch, wobei während eines Kalibrierungsschritts (52) für jeden Benutzer und für jeden primären Detektionsbereich ein Schwellenwert Sc einer Amplitude einer an der entsprechenden empfindlichen Struktur bewirkten Störung bestimmt wird, der repräsentativ für den Kontakt ohne Druck der Person mit diesem primären Detektionsbereich ist, wobei bei dem Verfahren vorzugsweise während eines Kalibrierungsschritts (53) für jeden Benutzer und für jeden primären Detektionsbereich ein Schwellenwert Spmax einer Amplitude einer an der empfindlichen Struktur bewirkten Störung bestimmt wird, der repräsentativ für einen von der Person auf diesen Detektionsbereich ausgeübten maximalen Druck ist, wobei das Intervall Sc-sPmax vorzugsweise so segmentiert ist, dass mindestens zwei Druckstufen unterschieden werden, und/oder wobei bei dem Verfahren während eines Kalibrierungsschritts (51) für jeden Benutzer und für jeden primären Detektionsbereich ein Schwellenwert Sprox einer Amplitude einer an der empfindlichen Struktur bewirkten Störung bestimmt wird, der einem Gelangen der Person, insbesondere ihrer Hand, in die Nähe des primären Detektionsbereichs, ohne ihren Kontakt mit diesem primären Detektionsbereich, entspricht.

10. Verfahren nach einem der Ansprüche 8 und 9, wobei eine Beschleunigung gemessen wird, der die Oberfläche ausgesetzt ist, und, wenn der Modul der Beschleunigung einen vordefinierten Schwellenwert überschreitet, die Messung der an den empfindlichen Strukturen bewirkten Störung ignoriert wird.

## Claims

1. Manoeuvring member equipped with a multipoint contact detection device (1), comprising:
- at least two capacitive or inductive sensitive structures (20), associated with respective primary detection zones (D2; D4; D6; D8) of a surface that a person is likely to contact, at least two of these sensitive structures being positioned with a separation that is small enough between them to define at least one intermediate detection zone (D1; D3; D5; D7) that the person is likely to contact while exerting a capacitive or inductive disturbance on the adjacent sensitive structures,
- a processing circuit (3) configured to
o detect, for each sensitive structure (20), a disturbance induced by the person coming into proximity or into contact, the processing circuit being arranged to generate a signal representative of the amplitude of the disturbance induced by the contact or the proximity of the person with each primary detection zone (D2; D4; D6; D8), and
o locate, from the duly detected disturbances, the primary detection zone or the intermediate detection zone with which the person comes into contact, the contact being considered to be made in an intermediate detection zone (D1; D3; D5; D7) when the disturbances induced on all or part of the primary detection zones (D2; D4; D6; D8) satisfy predefined relationships,
**characterized in that** the processing circuit is further configured to measure the contact pressure of the person with the primary detection zone or the intermediate detection zone, the processing circuit (3) being arranged to generate a signal representative of the amplitude of the disturbance induced by the contact pressure of the person with the primary detection zone or the intermediate detection zone.

2. Manoeuvring member according to Claim 1, the processing circuit (3) of the device (1) being arranged to detect the disturbance induced on the oscillation frequency of an oscillator with resonant circuit (34) of LC type, of which at least a part of the capacitance or of the inductance is formed by the sensitive structure (20), the processing circuit (3) of the device (1) preferably being arranged to generate a signal representative of the amplitude of the frequency variation induced by the contact pressure or the proximity of the person with each primary detection zone (D2; D4; D6; D8), the processing circuit (3) of the device (1) preferably being arranged to compare the signal representative of the amplitude of the disturbance induced on at least one sensitive structure (20) with at least one predefined threshold (Sprox; Sc; Spmax), or, better, with at least two predefined thresholds, and to generate from this comparison at least one piece of information relating to the contact pressure and/or to the extent of contact of the person on the associated primary detection zone and/or at least one piece of information relating to the location of the contact of the person on the surface.

3. Manoeuvring member according to either one of the preceding claims, the device (1) comprising at least one accelerometer (4), the processing circuit (3) of the device (1) being arranged to take account of the disturbance induced by the acceleration on the measurement performed by means of the sensitive structures (20).

4. Manoeuvring member according to Claim 3, the processing circuit (3) of the device (1) being arranged to disregard the result of the measurement performed by means of the sensitive structures (20) when the detected acceleration is greater than a predefined threshold.

5. Manoeuvring member according to any one of the preceding claims, the device (1) comprising at least three sensitive structures (20), or, better, at least four sensitive structures (20), defining at least five, even better at least eight, detection zones along the surface, notably four primary detection zones (D2, D4, D6, D8) and, between them, four intermediate detection zones (D1, D3, D5, D7).

6. Manoeuvring member according to any one of the preceding claims, the sensitive structures (20) of the device (1) being distributed on the manoeuvring member, notably a steering wheel (2), and the processing circuit (3) being arranged to deliver a piece of information representative of the position of the hand on the manoeuvring member.

7. Manoeuvring member according to any one of the preceding claims, the manoeuvring member being a steering wheel preferably comprising at least two electrodes (21) associated with one and the same primary detection zone on the steering wheel, these electrodes preferably being diametrically opposite when the manoeuvring member is observed in section.

8. Method for locating on a surface a point of contact of a person with this surface, using a device (1) of a manoeuvring member according to any one of Claims 1 to 6, wherein:
o for each sensitive structure (20), a disturbance induced by the person coming into contact or into proximity is detected, and
∘ from the duly detected disturbances, the primary detection zone (D2; D4; D6; D8) or the intermediate detection zone (D1; D3; D5; D7) with which the person comes into contact is located, the contact being considered to be made in an intermediate detection zone when the disturbances induced on all or part of the primary detection zones satisfy predefined relationships, notably when the disturbances induced on each of the two primary detection zones adjacent to this intermediate detection zone exceed a predefined threshold (Sprox), **characterized in that**, once the contact is located, the contact pressure is estimated, the induced disturbance increasing with the contact pressure of the hand situated facing the sensitive structure.

9. Method according to the preceding claim, wherein, during a calibration step (52) for each user and for each primary detection zone, a threshold Sc of amplitude of disturbance induced on the corresponding sensitive structure, representative of the contact without pressure of the person with this primary detection zone, is determined, in which method, preferably during a calibration step (53) for each user and for each primary detection zone, a threshold Spmax of amplitude of disturbance induced on the sensitive structure, representative of a maximum pressure exerted by the person on this detection zone, is determined, the range Sc-Spmax preferably being segmented to distinguish at least two pressure levels, and/or in which method, during a calibration step (51), for each user and for each primary detection zone, a threshold Sprox of amplitude of disturbance induced on the sensitive structure, corresponding to the person, notably his or her hand, coming into proximity with the primary detection zone, without contact thereof with this primary detection zone, is determined.

10. Method according to one of Claims 8 and 9, wherein an acceleration to which the surface is subjected is measured and, if the modulus of the acceleration exceeds a predefined threshold, the measurement of the disturbance induced on the sensitive structures is disregarded.
